# EUROPEAN PATENT APPLICATION

(11) **EP 4 312 261 A1**
(43) Date of publication of application: **31.01.2024**
(21) Application number: 22186786.4
(22) Date of filing: 25.07.2022
(51) Int. Cl.: H01L 23/473

(54) **COOLING DEVICE FOR SEMICONDUCTOR SWITCHING ELEMENTS, POWER INVERTER DEVICE AND ARRANGEMENT WITH A POWER INVERTER DEVICE AND AN ELECTRIC MACHINE**

(71) Applicant: Valeo eAutomotive Germany GmbH, 91056 Erlangen (DE)
(72) Inventor: RAYYA, Monzer, 91056 ERLANGEN (DE)
(74) Representative: Valeo Powertrain Systems

(57) **Abstract**

The invention relates to a cooling device (15) for cooling semiconductor switching elements (10, 11), comprising:
- a first wall (17) having a first surface (18) for carrying the semiconductor switching elements (10, 11) and having a second surface (19) being opposite the first surface (18), and
- a second wall (20) having a third surface (21) that forms a main cooling channel (22) together with the second surface (19) and having a fourth surface (25) being opposite to the third surface (21),
- a third wall (23) that forms an auxiliary cooling channel (24) together with the fourth surface (25),
wherein the second wall (20) comprises a nozzle (50), the nozzle (50) protruding from the third surface (21) of the second wall (20) toward second surface (19) of the first wall (17).

The invention also relates to an electrical power converter device and an arrangement comprising such an electrical power converter device.

## Description

The present invention relates to a cooling device for cooling semiconductor switching elements, comprising a first wall having a first surface for carrying the semiconductor switching elements and having a second surface being opposite the first surface, and a second wall having a third surface that forms a main cooling channel together with the second surface of the first wall and having a fourth surface being opposite to the third surface of the second wall.

Besides, the present invention relates to an electrical power converter such as a power inverter device and an arrangement with such an electrical power converter device and an electric machine.

When operating semiconductor switching elements, exemplarily within a power inverter device that supplies an electric machine of an electric driven vehicle, significant power losses are generated that may cause overtemperature failures of the semiconductor switching elements. It is known to use a cooling device for cooling the semiconductor switching elements that has a cooling channel in order to allow a coolant to flow subsequently along the semiconductor switching elements for cooling them. Therein, additional heat sink structures, such as pin fins, that extend into the cooling channel may be used, in order to generate turbulences in the coolant and to generate a larger heat exchange surface.

The document WO2021115897 A1 discloses cooling device for cooling semiconductor switching elements, comprising:
- a first wall having a first surface for carrying the semiconductor switching elements and having a second surface being opposite the first surface, and
- a second wall having a third surface that forms a main cooling channel together with the second surface of the first wall and having a fourth surface being opposite to the third surface of the second wall,
- a third wall that forms an auxiliary cooling channel together with the fourth surface of the second wall, wherein the second wall comprises a connection means that connects the auxiliary cooling channel with the main cooling channel in a fluid-conductive manner.

Such a cooling device improves the cooling of the first wall and thus the cooling of the switching devices however hot regions remain on the first wall especially in line with the switching elements. Such hot regions may lead to overheating and destruction of the switching elements.

The objective of the invention is to reduce or eliminate these disadvantages. The present invention relates to a cooling device for cooling semiconductor switching elements, comprising:
- a first wall having a first surface for carrying the semiconductor switching elements and having a second surface being opposite the first surface, and
- a second wall having a third surface that forms a main cooling channel together with the second surface of the first wall and having a fourth surface being opposite to the third surface of the second wall,
- a third wall that forms an auxiliary cooling channel together with the fourth surface of the second wall,
   wherein the second wall comprises a nozzle, the nozzle protruding from the third surface of the second wall toward second surface of the first wall, a through-hole extending in the nozzle so as to connect the auxiliary cooling channel with the main cooling channel in a fluid-conductive manner,
   the through-hole comprising an inlet formed in the fourth surface of the second wall and an outlet formed at an end of the nozzle facing the second surface of the first wall,
   a first distance between the end of the nozzle and the second surface of the first wall being smaller than a second distance between the third surface of the second wall and the second surface of the first wall.
Thanks to the use of such a nozzle the flow of coolant can be increased on the second face of the first wall at a location where a high heat transfer is needed. The location is for example opposite the semiconductor switching elements. Moreover the coolant flowing in the auxiliary channel and in the nozzle is cooler than the coolant flowing in the main cooling channel. This difference in coolant temperature is due to the direct contact between coolant flowing in the main cooling channel and the first wall contrary to the auxiliary channel which is distant from the first wall and the semiconductor switching elements. Thus the invention allows an improved heat dissipation from the semiconductor switching elements.

Moreover the short first distance between the end of the nozzle and the second surface of the first wall increases the speed of a coolant flow in the main cooling channel locally between the end of the nozzle and the second surface. This locally increased speed create a Venturi effect sucking the coolant from the auxiliary cooling channel to the main cooling channel. Thus the coolant flow in the nozzle is increased and the heat dissipation from the semiconductor switching elements is improved.

According to a further development of the present invention, the first distance is greater or equal to 0.05 mm and less than or equal to 1 mm.

Thanks to such a first distance the coolant flowing from the auxiliary cooling channel to the main cooling channel is focused on areas of the first wall where a high heat dissipation is needed. Such a first distance also improves the Venturi effect and thus increases the coolant flow from the auxiliary cooling channel to the main cooling channel.

According to a further development of the present invention, the through-hole has a cross sectional area greater or equal to 0.008 mm² and less than or equal to 12 mm².

According to a further development of the present invention, the through-hole is straight along a through-hole axis, a first angle between the through-hole axis and a first plane tangent to the third surface of the second wall being greater or equal to 30° and less than or equal to 90°.

According to a further development of the present invention, the cooling device further comprises:
- an inlet channel assembly able to supplying a coolant to the main cooling channel and to the auxiliary cooling channel, and
- an outlet channel able to drain the coolant out of the main cooling channel,
   a global coolant flow direction being defined between the inlet channel assembly and the outlet channel.

According to a further development of the present invention, a width of the nozzle in a direction perpendicular to the global coolant flow direction and tangent to the third surface is greater or equal to 1 mm and less than or equal to 10 mm.

Such a width of the nozzle reduce the pressure drop in the main cooling channel while increasing the coolant speed between the end of the nozzle and the second surface. Therefore, the coolant flow is improved and the cooling of the semiconductor switching elements is increased.

According to a further development of the present invention, the nozzle is cylindrical.

According to a further development of the present invention, the nozzle is able to spray a cooling fluid on the second surface of the first wall at a location in line with one of the semiconductor switching elements.

According to a further development of the present invention, the cooling device comprises a plurality of nozzles.

Such a plurality of nozzles allows the coolant to be sprayed on different locations of the second surface of the first wall. For example each semiconductor switching element is cooled by its own nozzle. Therefore the cooling of each semiconductor switching element is improved.

According to a further development of the present invention, a first nozzle and a second nozzle of the plurality of nozzles are distant in a direction perpendicular to the global coolant flow direction and tangent to the third surface,
a separation wall, in particular formed in the second wall, splitting the auxiliary cooling channel between a first inlet of the first nozzle and a second inlet of the second nozzle.

Thank to this separation wall, the coolant flow in the first nozzle and the coolant flow in the second nozzle are balanced.

According to a further development of the present invention, the second wall comprises a turbulator structure on the third surface of the second wall, the turbulator structure comprising projections projecting toward the second surface of the first wall.

Such a turbulator structure generates turbulences in the coolant below the first wall which carries the semiconductor switching elements. These turbulences improve the heat transfert between the coolant and the first wall. The need of additional ribbon bonds or pin fins is prevented. The cooling of the semiconductor switching elements is improved.

According to a further development of the present invention, a third distance between the projections and the second surface of the first wall is greater than the first distance between the end of the nozzle and the second surface of the first wall.

Thanks to such a third distance, the pressure drop in the main cooling channel is reduced. The cooling of the semiconductor switching elements is improved. According to a further development of the present invention, the projections are triangular prisms, the edge of the triangular prisms being the closest to the second surface of the first wall being perpendicular to the global coolant flow direction. According to a further development of the present invention, the projections are arranged in rows perpendicular to the global coolant flow direction,
adjacent projections being staggered in the direction perpendicular to the global coolant flow direction.

Such staggered projections reduce the pressure drop in the main cooling channel. The cooling of the semiconductor switching elements is improved.

The invention also relates to an electrical power converter device comprising a plurality of semiconductor switching elements and a cooling device for the semiconductor switching elements as was described above.

The invention also relates to an arrangement comprising an electrical power converter device as was described above and an electric machine being configured to drive a vehicle, wherein the electrical power converter device is a power inverter device configured to supply the electric machine.

According to a further development of the present invention, the electric machine is configured to drive a vehicle.

The invention will be better understood by reading the following description and examining the figures which accompany it. These figures are provided purely by way of illustration and in no way limit the invention:
- Fig. 1 shows a block diagram of a first embodiment of an electrical power converter device according to the invention,
- Fig. 2 shows a schematic top-view of the first embodiment of the electrical power converter device,
- Fig. 3 shows a schematic longitudinal section of the first embodiment of the electrical power converter device having a first embodiment of a cooling device according to the invention,
- Fig. 4 shows a schematic top view of the first embodiment of the cooling device,
- Fig. 5 shows a schematic partial longitudinal section of the first embodiment of the electrical power converter of Fig. 3,
- Fig. 6 shows a schematic view of the second wall of the first embodiment of the cooling device,
- Fig. 7 shows another schematic view of the second wall of the first embodiment of the cooling device,
- Fig. 8 shows a schematic cross-sectional view of the first embodiment of the electrical power converter,
- Fig. 9 shows a top-view of a fixing element of the first embodiment of the cooling device,
- Fig. 10 shows a partial schematic view of a second embodiment of the cooling device,
- Fig. 11 shows a schematic partial longitudinal section of a second embodiment of the electrical power converter having the second embodiment of the cooling device of Fig. 10.

The elements which are identical, similar or analogous retain the same reference from one figure to another. The ordinal numbers are used to differentiate features. They do not define a position of a feature. As a consequence, for example, a third feature of a product does not mean that the product has a first and/or a second feature.

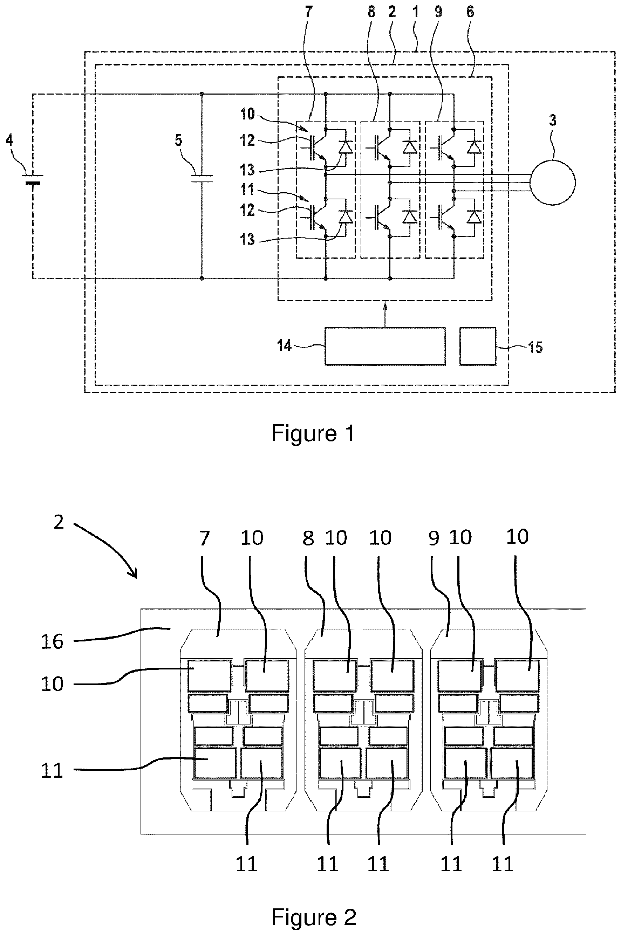

Fig. 1 is a block diagram of an embodiment of an arrangement 1 with an electrical power converter device 2 and an electric machine 3. The electrical power converter device 2 is a power inverter device 2 configured to supply the electric machine 3. The electric machine 3 is suitable for driving a vehicle such as a battery electric vehicle or a hybrid electric vehicle. Furthermore, Fig. 1 shows a high-voltage battery 4 connected to a DC link of the power inverter device 2 or to the arrangement 1, respectively.

The power inverter device 2 comprises a DC link capacitor 5, and a semiconductor switching element module 6 having a first semiconductor switching element arrangement 7, a second semiconductor switching element arrangement 8 and a third semiconductor switching element arrangement 9. Each semiconductor switching element arrangement 7, 8, 9 is configured to provide an output phase current of the power inverter device 2. Thereto, each semiconductor switching element arrangement 7, 8, 9 comprises a half-bridge formed by two semiconductor switching elements 10, 11. Each semiconductor switching element has a transistor structure 12 and an antiparallel diode structure 13. The transistor structure 12 and the diode structure 13 may be formed by one or multiple Power-MOSFETs or by one or multiple connections of an IGBT and a diode. Furthermore, the power inverter device 2 comprises a control unit 14 being configured to control the semiconductor switching element module 6 or the semiconductor switching element arrangements 7, 8, 9, respectively, so as to provide a three-phase output voltage.

In another embodiment not shown, the power inverter device comprises a different number of semiconductor switching element arrangements, for example six switching element arrangements to provide two three-phase output voltages.

The power inverter device 2 further comprises a first embodiment of a cooling device 15 for cooling the semiconductor switching elements 10, 11.

Fig. 2 is a top view of the first embodiment of the power inverter device 2. For example, the semiconductor switching element arrangements 7, 8, 9 are mounted in a row upon a base plate 16 of the cooling device 15.

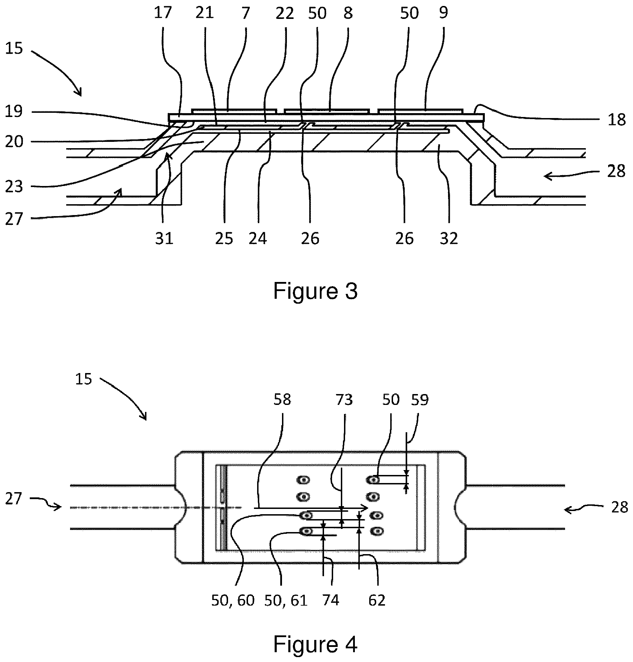

Fig. 3 is a longitudinal section of the first embodiment of the power inverter device 2 having the cooling device 15.

The cooling device 15 comprises:
- a first wall 17 having a first surface 18 for carrying the semiconductor switching elements 10, 11 and having a second surface 19 being opposite the first surface 18, and
- a second wall 20 having a third surface 21 that forms a main cooling channel 22 together with the second surface 19 of the first wall 17 and having a fourth surface 25 being opposite to the third surface 21 of the second wall 20,
- a third wall 23 that forms an auxiliary cooling channel 24 together with the fourth surface 25 of the second wall 20.

The second wall 20 comprises a nozzle 50. The nozzle 50 protrudes from the third surface 21 of the second wall 20 toward second surface 19 of the first wall 17. A through-hole 26 extends in the nozzle 50 so as to connect the auxiliary cooling channel 24 with the main cooling channel 22 in a fluid-conductive manner. The through-hole 26 comprises an inlet 51 formed in the fourth surface 25 of the second wall 20 and an outlet 52 formed at an end 53 of the nozzle 50 facing the second surface 19 of the first wall 17. A first distance 54 between the end 53 of the nozzle 50 and the second surface 19 of the first wall 17 is smaller than a second distance 55 between the third surface 21 of the second wall 20 and the second surface 19 of the first wall 17.

For example, the first wall 17 is formed by the base plate 16. For example, the main cooling channel 22 and the auxiliary cooling channel 24 extend in parallel below the base plate 16, which is in direct thermal contact with a coolant stream along the main cooling channel 22.

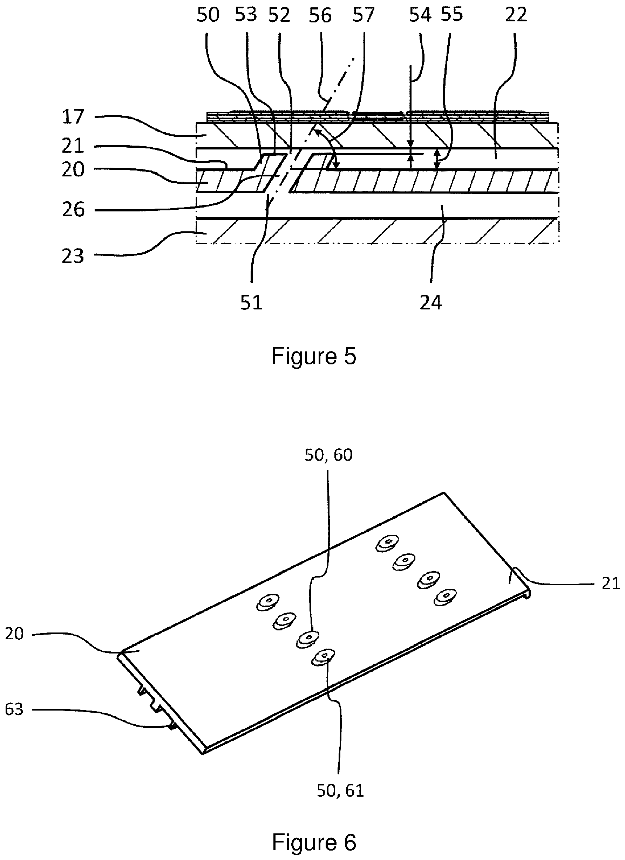

Fig. 5 is a schematic partial longitudinal section of the first embodiment of the electrical power converter showing in particular details of the nozzle 50.

For example, the first distance 54 is greater or equal to 0.05 mm and less than or equal to 1 mm.

For example, the end 52 of the nozzle 50 and the second surface 19 are parallel. For example, the through-hole 26 has a cross sectional area greater or equal to 0.008 mm² and less than or equal to 12 mm².

The through-hole 26 has, for example, the shape of a right circular cylinder.

In another embodiment not shown, the through-hole has the shape of an oblique circular cylinder.

For example, the through-hole 26 is straight along a through-hole axis 56. For example, a first angle 57 between the through-hole axis 56 and a first plane tangent to the third surface 21 of the second wall 20 is greater or equal to 30° and less than or equal to 90°.

The cooling device 15 may comprise a plurality of nozzles 50 as the embodiments shown on the figures. For example, Fig. 4 shows the first embodiment of the cooling device 15 comprising eight nozzles 50.

In another embodiment not shown, the cooling device comprises as many nozzles as semiconductor switching elements 10, 11.

The cooling device 15 may further comprise:
- an inlet channel assembly 27 for supplying a coolant to the main cooling channel 22 and to the auxiliary cooling channel 24, and
- an outlet channel 28 for draining the coolant out of the main cooling channel 22. A global coolant flow direction 58 is defined between the inlet channel assembly 27 and the outlet channel 28.

As shown in Fig. 3, for example, the outlet channel 28 is provided on the opposite side with respect to the inlet channel assembly 27 of the cooling device 15. For instance, the inlet channel assembly 27 comprises a common inlet channel 31 supplying the coolant to the auxiliary cooling channel 24 and to a main inlet channel 29 for supplying the coolant to the main cooling channel 22.

For example, the inlet channel assembly 27 and the outlet channel 28 are formed by inclined bores within a housing element 32, exemplarily made of aluminum. The nozzle 50 has a width 59 in a direction perpendicular to the global coolant flow direction 58 and tangent to the third surface 21. For example the width 59 is greater or equal to 1 mm and less than or equal to 10 mm.

For example the nozzle 50 is cylindrical. For instance, the nozzle 50 has a shape of a right circular cylinder. The right circular cylinder shape is, for example, truncated so that the end 52 of the nozzle 50 and the second surface 19 are parallel.

In another embodiment not shown, the nozzle has the shape of an oblique circular cylinder.

For example, the nozzle 50 is straight along a nozzle axis. For example, a second angle between the nozzle axis and a first plane tangent to the third surface 21 of the second wall 20 is greater or equal to 30° and less than or equal to 90°. For instance, the nozzle axis and the through-hole axis 56 coincide.

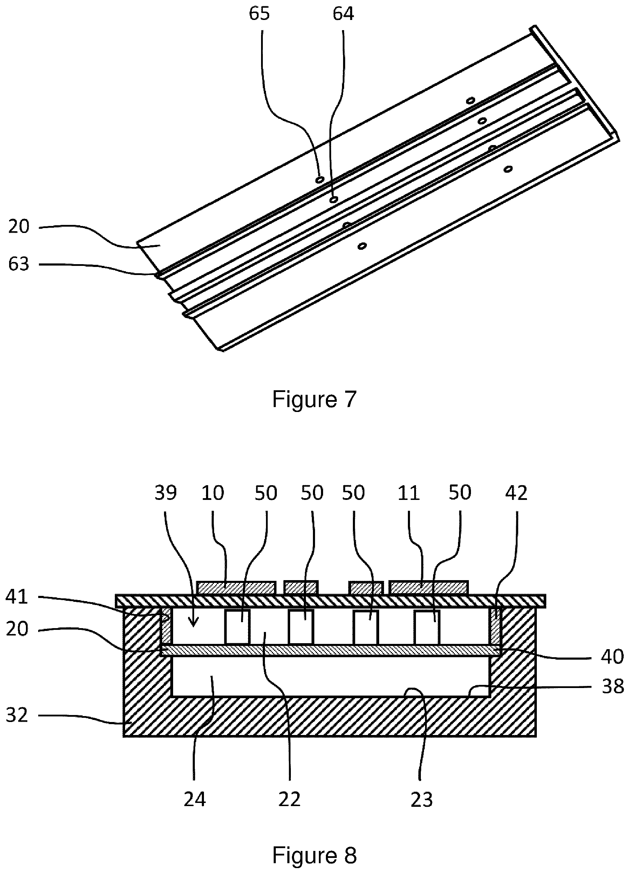

For example, the nozzle 50 is able to spray a coolant on the second surface 19 of the first wall 17 in particular at a location in line with one of the semiconductor switching elements 10, 11. It means that the nozzle can spray the coolant on the second surface at location opposite the semiconductor switching elements 10, 11. The coolant is for example a cooling fluid such as a cooling liquid or a cooling gaz. Fig. 6 and Fig. 7 show the second wall 20 of the first embodiment of the cooling device. The plurality of nozzles 50 may comprise a first nozzle 60 and a second nozzle 61. For example, the first nozzle 60 and the second nozzle 61 are distant in a direction perpendicular to the global coolant flow direction 58 and tangent to the third surface 21. A separation wall 63 may split the auxiliary cooling channel 24 between a first inlet 64 of the first nozzle 60 and a second inlet 65 of the second nozzle 61. For instance, the separation wall 63 is formed in the second wall 20.

In another embodiment not shown, the separation wall is formed in the third wall 24.

For example, the cooling device comprises three separation walls 63 as shown in Fig. 6 and Fig. 7.

The first nozzle 60 has a first width 73 in a direction perpendicular to the global coolant flow direction 58 and tangent to the third surface 21. The second nozzle 61 has a second width 74 in a direction perpendicular to the global coolant flow direction 58 and tangent to the third surface 21. For example, a fourth distance 62 between the first nozzle 60 and the second nozzle 61 in a direction perpendicular to the global coolant flow direction 58 and tangent to the third surface 21 is lower than the average width of the first width 73 of the first nozzle 60 and the second width 74 of the second nozzle 61.

Fig. 8 is a cross-section view of the first embodiment of the power inverter device 2 along a plane perpendicular to the global coolant flow direction 58.

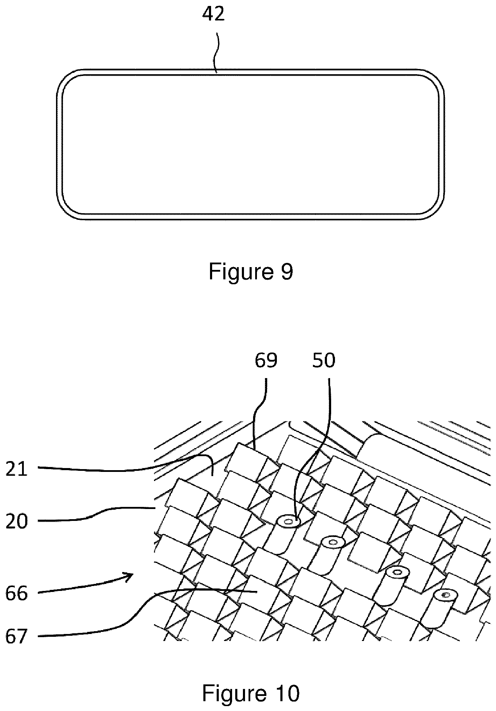

For example, the third wall 23 is formed by a bottom 38 of a cavity 39 formed within the housing element 32. For instance, the second wall 20 is formed by a plate-like separation element 40 being arranged on a recess 41 of the cavity 39. A fixing element 42, which is depicted in Fig. 9, may be provided between the base plate 16 and the separation element 40. The fixing element 42 is, for example, elastically deformed by the base plate 16, when the base plate 16 closes the cavity 39.

In another embodiment of the invention not shown, the second wall 20 is formed with the housing element by additive manufacturing.

Fig. 10 shows a partial view of a second embodiment of the cooling device. The second embodiment of the cooling device is similar to the first embodiment of the cooling device.

In the second embodiment of the cooling device, the second wall 20 comprises a turbulator structure 66 on the third surface 21 of the second wall 20. The turbulator structure 66 comprises projections 67 projecting toward the second surface 19 of the first wall 17.

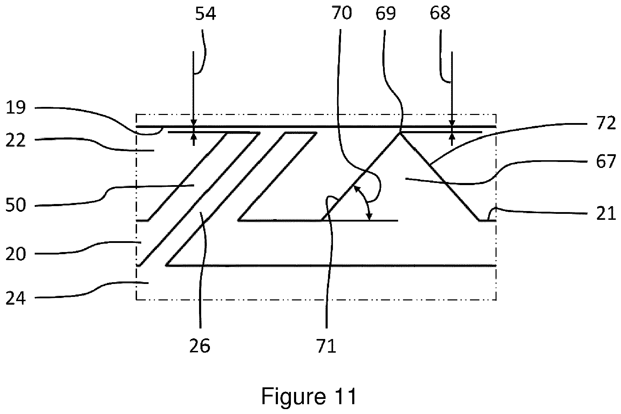

Fig. 11 shows a schematic partial longitudinal section of a second embodiment of the electrical power converter comprising the second embodiment of the cooling device.

For example, a third distance 68 between the projections and the second surface 19 of the first wall 17 is greater than the first distance 54 between the end 53 of the nozzle 50 and the second surface 19 of the first wall 17. For example, the third distance 68 is greater or equal to 0.05 mm and less than or equal to 2 mm.

The projections 67 are, for example, triangular prisms. The triangular prisms have an edge 69. The edge 69 of the triangular prisms is the closest to the second surface 19 of the first wall 17. The edge 69 is, for example, perpendicular to the global coolant flow direction 58. Each triangular prism has, for example, a front face 71 and a back face 72. The front face 71 and the back face 72 join at the edge 69. The front face 71 is the first face of the triangular prisms in contact with the fluid flowing in the global coolant flow direction 58. For example, a third angle 70 between the front face 71 and a first plane tangent to the third surface 21 of the second wall 20 is greater or equal to 30° and less than or equal to 90°.

For example, the projections 67 are arranged in rows perpendicular to the global coolant flow direction 58. Adjacent projections 67 are for example staggered in the direction perpendicular to the global coolant flow direction 58.

In another embodiment not shown, the electric power converter is a DC-DC converter.

In another embodiment not shown, the electric power converter is a charger converting alternating current into direct current.

## Claims

1. Cooling device (15) for cooling semiconductor switching elements (10, 11), comprising:
- a first wall (17) having a first surface (18) for carrying the semiconductor switching elements (10, 11) and having a second surface (19) being opposite the first surface (18), and
- a second wall (20) having a third surface (21) that forms a main cooling channel (22) together with the second surface (19) of the first wall (17) and having a fourth surface (25) being opposite to the third surface (21) of the second wall (20),
- a third wall (23) that forms an auxiliary cooling channel (24) together with the fourth surface (25) of the second wall (20),
wherein the second wall (20) comprises a nozzle (50), the nozzle (50) protruding from the third surface (21) of the second wall (20) toward second surface (19) of the first wall (17), a through-hole (26) extending in the nozzle (50) so as to connect the auxiliary cooling channel (24) with the main cooling channel (22) in a fluid-conductive manner,
the through-hole (26) comprising an inlet (51) formed in the fourth surface (25) of the second wall (20) and an outlet (52) formed at an end (53) of the nozzle (50) facing the second surface (19) of the first wall (17),
a first distance (54) between the end (53) of the nozzle (50) and the second surface (19) of the first wall (17) being smaller than a second distance (55) between the third surface (21) of the second wall (20) and the second surface (19) of the first wall (17).

2. Cooling device (15) according to claim 1, wherein the first distance (54) is greater or equal to 0.05 mm and less than or equal to 1 mm.

3. Cooling device (15) according to one of the preceding claims wherein the through-hole (26) has a cross sectional area greater or equal to 0.008 mm² and less than or equal to 12 mm².

4. Cooling device (15) according to one of the preceding claims wherein the through-hole (26) is straight along a through-hole axis (56), a first angle (57) between the through-hole axis (56) and a first plane tangent to the third surface (21) of the second wall (20) being greater or equal to 30° and less than or equal to 90°.

5. Cooling device (15) according to one of the preceding claims, further comprising:
- an inlet channel assembly (27) able to supplying a coolant to the main cooling channel (22) and to the auxiliary cooling channel (24), and
- an outlet channel (28) able to drain the coolant out of the main cooling channel (22),
a global coolant flow direction (58) being defined between the inlet channel assembly (27) and the outlet channel (28).

6. Cooling device (15) according to the preceding claim wherein a width (59) of the nozzle (50) in a direction perpendicular to the global coolant flow direction (58) and tangent to the third surface (21) is greater or equal to 1 mm and less than or equal to 10 mm.

7. Cooling device (15) according to one of the preceding claims wherein the nozzle (50) is able to spray a cooling fluid on the second surface (19) of the first wall (17) at a location in line with one of the semiconductor switching elements (10, 11).

8. Cooling device (15) according to one of the preceding claims comprising a plurality of nozzles (50).

9. Cooling device (15) according to the preceding claim in combination with claim 5 wherein a first nozzle (60) and a second nozzle (61) of the plurality of nozzles (50) are distant in a direction perpendicular to the global coolant flow direction (58) and tangent to the third surface (21),
a separation wall (63), in particular formed in the second wall (20), splitting the auxiliary cooling channel (24) between a first inlet (64) of the first nozzle (60) and a second inlet (65) of the second nozzle (61).

10. Cooling device (15) according to one of the preceding claims wherein the second wall (20) comprises a turbulator structure (66) on the third surface (21) of the second wall (20), the turbulator structure (66) comprising projections (67) projecting toward the second surface (19) of the first wall (17).

11. Cooling device (15) according to the preceding claim wherein a third distance (68) between the projections and the second surface (19) of the first wall (17) being greater than the first distance (54) between the end (53) of the nozzle (50) and the second surface (19) of the first wall (17).

12. Cooling device according to one of claims 10 and 11 in combination with claim 5 wherein the projections (67) are triangular prisms, the edge (69) of the triangular prisms being the closest to the second surface (19) of the first wall (17) being perpendicular to the global coolant flow direction (58).

13. Cooling device according to one of claim 10 to 12 in combination with claim 5 wherein the projections (67) are arranged in rows perpendicular to the global coolant flow direction (58),
adjacent projections (67) being staggered in the direction perpendicular to the global coolant flow direction (58).

14. Electrical power converter device (2), comprising a plurality of semiconductor switching elements (10, 11) and a cooling device (15) for the semiconductor switching elements (10, 11) according to any of the preceding claims.

15. Arrangement (1) comprising an electrical power converter device (2) according to claim 14 and an electric machine (3), wherein the electrical power converter device is a power inverter device (2) configured to supply the electric machine (3).
